# EUROPÄISCHE PATENTSCHRIFT

(11) **EP 1 261 879 B1**
(45) Veröffentlichungstag und Bekanntmachung des Hinweises auf die Patenterteilung: **25.02.2004**
(21) Anmeldenummer: 01923632.2
(22) Anmeldetag: 05.03.2001
(51) Int. Cl.: G01R 15/18, H01F 38/28, H01F 27/42

(54) **STROMWANDLER FÜR EINEN KOMPENSATIONSSTROMSENSOR**
CURRENT TRANSFORMER FOR A COMPENSATING CURRENT SENSOR
TRANSFORMATEUR DE COURANT POUR DETECTEUR DE COURANT DE COMPENSATION

(30) Priorität: 07.03.2000 DE 10011050
(43) Veröffentlichungstag der Anmeldung: 04.12.2002
(73) Patentinhaber: Vacuumschmelze GmbH & Co. KG, 63450 Hanau (DE)
(72) Erfinder: PREUSSE, Norbert, 63755 Alzenau (DE); LENHARD, Friedrich, 63452 Hanau (DE); SCHÄFER, Stefan, 55452 Rümmelsheim (DE)
(74) Vertreter: Schmuckermaier, Bernhard
(86) Internationale Anmeldenummer: PCT/EP2001/002460
(87) Internationale Veröffentlichungsnummer: WO 2001/067117

(56) Entgegenhaltungen:
- EP-A- 0 365 216
- US-A- 4 182 982
- US-A- 4 492 919

## Beschreibung

Die Erfindung betrifft einen Stromwandler für einen Kompensationsstromsensor mit mindestens einem Primärleiter, einer Sekundärwicklung und einem weichmagnetischen Kern, bei dem der Kern durch die Sekundärwicklung nicht vollständig umwickelt ist, bei dem Primärleiter und Sekundärwicklung elektrisch voneinander isoliert und magnetisch durch den Kern miteinander gekoppelt sind und bei dem der Primärleiter zur Einspeisung eines zu erfassenden Stromes und die Sekundärwicklung zur Einspeisung eines Kompensationsstromes vorgesehen ist.

Stromsensoren sollen einerseits klein und kostengünstig sein, andererseits aber einen großen Messbereich haben. Bevorzugt werden dabei Stromsensoren nach dem Kompensationsprinzip (Kompensationsstromsensoren) verwendet. Ein derartiger Kompensationsstromsensor ist beispielsweise aus der EP 0 294 590 bekannt. Dabei wird bei einem Stromwandler das in dessen weichmagnetischen Kern von dem zu erfassenden, durch Strom erzeugte Magnetfeld durch ein Magnetfeld kompensiert, das von einem in die Sekundärwicklung eingespeisten Kompensationsstrom erzeugt wird. Der bekannte Kompensationsstromsensor weist einen ringförmigen Kern auf, durch den der den zu erfassenden Strom führende Primärleiter hindurchgeführt wird und der mit der Sekundärwicklung über den ganzen Umfang umwickelt ist. Durch letzteres wird eine gleichmäßige Verteilung des magnetischen Flusses über den gesamten Umfang des Kerns erreicht, wodurch vorteilhafterweise ein großer Messbereich erzielt wird.

Jedoch ist ein vollständiges Umwickeln des Kerns für viele Anwendungen zu aufwendig und/oder konstruktiv zu schwierig. Problematisch ist dabei aber, dass bei Stromsensoren mit nur teilweise umwickeltem Kern der Fluss nur in einem bestimmten Bereich des Kerns eingespeist wird, in dem auch in der Regel die Magnetfeldsonde angeordnet ist. In diesem Bereich wird der magnetische Fluss durch die Kompensationswicklung zu Null kompensiert. Da sich der Fluss der den Kern nur teilweise umschließenden Kompensationswicklung nicht vollständig über den Kern, sondern sich teilweise als Streufluss im freien Raum schließt, wird der Fluss im Kern außerhalb der Kompensationswicklung nicht mehr vollständig kompensiert. Bei ansteigender Stromstärke kann daher außerhalb der Kompensationswicklung das Material in Sättigung gehen. Durch diesen Sättigungseffekt wird dann der lineare Messbereich des Stromwandlers und damit des gesamten Kompensationsstromsensors begrenzt. Jedoch ist auch bei diesen Anwendungen in der Regel ein größerer Messbereich wünschenswert.

Es ist bekannt, durch eine Aufteilung des Primärleiters eine Messbereichserweiterung zu erreichen, indem ein Teil des Stromes durch den Stromsensor geführt wird und ein Teil am Sensor vorbei geleitet wird. Die Messbereichserweiterung entspricht dabei exakt dem Aufteilungsverhältnis des zu messenden Stromes. Das bedeutet, dass mit einer Stromaufteilung von 1:4 eine Messbereichserweiterung von 5 erreicht wird.

Beispielsweise aus der DE-OS 2 303 906 ist es bekannt, den aufgeteilten Primärleiter um den Kern herumzuführen. Dabei wird ein Wechselstromwandler realisiert, der mit einer Kurzschlusswicklung ausgestattet ist. Damit wird der Fluss im Kern um den Quotienten aus der Impedanz dieser Kurzschlusswicklung und dem Ohm'schen Widerstand der Kurzschlusswicklung unterdrückt. Eine Aufnehmerspule liefert eine der zeitlichen Änderung des Magnetflusses und damit dem erregenden Strom proportionale Spannung. Dabei handelt es sich aber zum einen um eine Anordnung, die nur mit Wechselstrom zu betreiben ist, und zum anderen ist die Ausgangsspannung stark abhängig vom Ohm'schen Widerstand des Kurzschlussringes und damit von der Temperatur. Jedoch wird auch auf diese Weise keine befriedigende Erweiterung des Messbereichs erzielt.

Aufgabe der Erfindung ist es, einen Stromwandler für einen Kompensationsstromsensor anzugeben, der trotz geringem Aufwand einen großen Messbereich hat.

Die Aufgabe wird durch einen Stromwandler gemäß Patentanspruch 1 gelöst. Ausgestaltungen und Weiterbildungen des Erfindungsgedankens sind Gegenstand von Unteransprüchen.

Vorteil der Erfindung ist es, dass kleinere Kerne und/oder eine unsymmetrische Bewicklung verwendet werden können, da Sättigungseffekte und unhomogene magnetische Flüsse weitgehend kompensiert werden.

Im einzelnen ist bei einem Stromwandler der eingangs genannten Art mindestens ein zusätzlicher Leiter vorgesehen, der der Primärwicklung elektrisch parallel geschaltet ist und der in dem Bereich des Kerns angeordnet, an dem eine Flussüberhöhung auftritt, und zwar derart, dass die Flussüberhöhung zumindest teilweise kompensiert wird.

Die Erfindung basiert darauf, dass zunächst mittels des zusätzlichen Leiters eine Stromaufteilung und damit eine Messbereichserweiterung im herkömmlichen Sinne bewirkt wird, jedoch eine darüber hinaus gehende Messbereichserweiterung durch die besondere Anordnung des zusätzlichen Leiters erzielt wird. Der außen am Kern vorbei geführte zusätzliche Leiter wird nun so platziert, dass der durch diesen Teil des Primärleiters (zusätzlicher Leiter) eingespeiste Magnetfluss den Magnetfluss in den Außenbereichen des Kernes kompensiert. Das bedeutet, dass der von diesem Teil des Primärleiters (zusätzlicher Leiter) ausgehende Magnetfluss im Kern den Streufluss der Kompensationswicklung ersetzt, welcher zur Kompensation fehlt. Es werden auf diese Weise Messbereichserweiterungen erreicht, die weit über die durch herkömmliche Stromaufteilung erzielbare Werte hinausgehen.

Insbesondere wird dabei der zusätzliche Leiter neben dem Kern angeordnet derart, dass nur bestimmte Bereiche des Kerns von dessen magnetischen Fluss erfasst werden.

Beispielsweise bei mehreren, an unterschiedlichen Orten des Kerns auftretenden Flussüberhöhungen kann mindestens ein weiterer zusätzlicher Leiter vorgesehen werden, der Primärleiter und zusätzlichem Leiter elektrisch parallel geschaltet ist und der neben dem Kern angeordnet ist derart, dass nur bestimmte Bereiche des Kerns von dessen magnetischen Fluss entsprechend erfasst werden.

Bevorzugt führen Primärleiter und zusätzliche(r) Leiter Ströme unterschiedlicher Stärke, wobei die Ströme in Summe den zu erfassenden Strom ergeben. Auf diese Weise lässt sich zu jeder Geometrie (Kern und Wicklungen) durch eine optimale Stromaufteilung ein Maximum an Linearität und damit ein maximaler Messbereich erzielen.

Wenn Primärleiter und zusätzliche(r) Leiter nicht gewickelt sind, d. h. Windungszahlen kleiner als eins aufweisen, können beispielsweise sogenannte Durchsteckwandler realisiert werden, bei denen der den zu erfassenden Strom führende Primärleiter durch einen ringartigen Kern hindurchgeführt wird.

Dazu können bei einer bevorzugten Ausführungsform Primärleiter und zusätzliche(r) Leiter durch einen im Bereich des Kerns im wesentlichen geradlinigen Leiter oder einen im Bereich des Kerns im wesentlichen u-förmigen Leiter gebildet werden. Die u-förmige Ausbildung von Primärleiter und zusätzliche(n) Leiter(n) unter Ineinanderschachteln der einzelnen Leiter vergrößert den Messbereich weiter, da insbesondere die U-Form eine geringe Sättigung des Kerns bewirkt.

Werden Primärleiter und zusätzliche(r) Leiter durch einen einzigen geschlitzten Leiter gebildet, dann ergeben sich vorteilhafterweise keine sich mit der Zeit oder der Temperatur ändernde Übergangswiderstände an den andernfalls notwendigen Kontaktstellen von Primärleiter und zusätzlichem Leiter untereinander, wodurch die Messgenauigkeit verbessert wird.

Ein rückführender Leiter, der neben dem Kern auf der dem/den anderen zusätzlichen Leiter(n) entgegengesetzten Seite des Kerns angeordnet ist und der von dem zu erfassenden Strom in entgegengesetzter Richtung gegenüber Primärleiter und zusätzlichen Leitern durchflossen wird, kann darüber hinaus ebenfalls die Messgenauigkeit erhöhen, indem er negative Flussüberhöhungen kompensiert.

Primärleiter und zusätzliche(r) Leiter, Sekundärwicklung und Kern können schließlich zumindest teilweise, einzeln oder zusammen von einem Abschirmblech umgeben sein. Damit wird der Kern entlastet und der Einfluss von Störfeldern reduziert, die sich ungünstig auf den Messbereich auswirken würden.

Die Erfindung wird nachfolgend anhand der in den Figuren der Zeichnung dargestellten Ausführungsbeispiele näher erläutert. Es zeigt:
- Figur 1: eine erste allgemeine Ausführungsform eines erfindungsgemäßen Stromwandlers,
- Figur 2: eine zweite Ausführungsform eines erfindungsgemäßen Stromwandlers mit einem einen entgegengesetzten Strom führenden Leiter,
- Figur 3: eine dritte Ausführungsform eines erfindungsgemäßen Stromwandlers mit zwei ineinander geschachtelten u-förmigen Leitern,
- Figur 4: eine gegenüber der in Figur 3 gezeigten Ausführungsform um eine weitere Sekundärspule erweiterte vierte Ausführungsform eines erfindungsgemäßen Stromwandlers,
- Figur 5: eine fünfte Ausführungsform eines erfindungsgemäßen Stromwandlers mit Abschirmblech,
- Figur 6: eine sechste Ausführungsform eines erfindungsgemäßen Stromwandlers mit einem geschlitzten einstückigen Leiter,
- Figur 7: den Aufbau eines bevorzugten einstückigen, geschlitzten Leiters im Detail,
- Figur 8: eine siebte Ausführungsform eines erfindungsgemäßen Stromwandlers mit zwei neben dem Kern angeordneten Leitern,
- Figur 9: den Feldlinienverlauf eines erfindungsgemäßen Stromwandlers mit zwei Primärleitern im Vergleich zu einem herkömmlichen Stromwandler und
- Figur 10: den Feldlinienverlauf eines erfindungsgemäßen Stromwandlers mit Abschirmblech im Vergleich zu einem herkömmlichen Stromwandler.

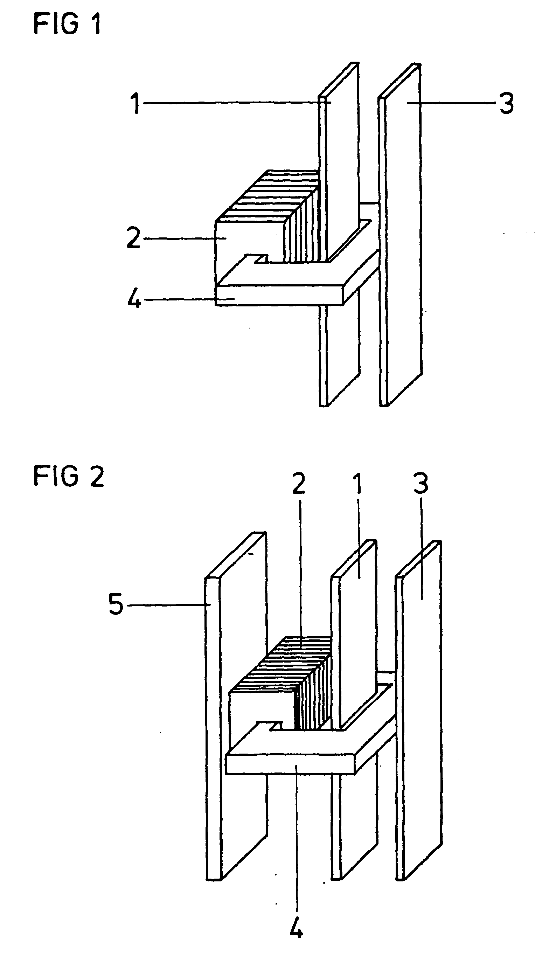

Bei der in Figur 1 gezeigten Ausführungsform eines erfindungsgemäßen Stromwandlers ist neben einem Primärleiter und einer Sekundärwicklung 2 ein zusätzlicher Leiter vorgesehen, wobei Primärleiter und zusätzlicher Leiter jeweils als Streifenleiter 1 bzw. 3 ausgebildet sind. Statt Streifenleitern könnte in gleicher Weise auch jede andere Leiterform Verwendung finden. Die Sekundärwicklung 2 hat eine Vielzahl von Windungen und ist über einem (in Figur 1 nicht dargestellten) Luftspalt eines weichmagnetischen Kerns 4 diesen umgebend angeordnet. Der Kern 4 hat einen im wesentlichen rechteckförmigen Querschnitt und ist ausgehend von dem Luftspalt ringförmig ausgebildet derart, dass die Grundfläche in etwa rechteckförmig ist. Anstelle einer rechteckigen Grundfläche und eines rechteckförmigen Querschnitts könnte aber jede beliebige, eine Ringform des Kerns 4 ermöglichende Grund- und Querschnittsfläche wie beispielsweise eine ovale, runde Fläche etc. verwendet werden.

Der Streifenleiter 1 (Primärleiter) durchdringt dabei die Grundfläche des Kerns 4 im wesentlichen geradlinig derart, dass er vom Kern 4 abgesehen von dessen Luftspalt über den vollen Umfang umschlossen wird. Die Sekundärwicklung 2 umgibt dabei nur einen Teil des Kerns 4 (beim Ausführungsbeispiel kleiner ein Viertel des Umfangs). Erfindungsgemäß ist ein zweiter Streifenleiter 3 (zusätzlicher Leiter), der dem ersten Streifenleiter 1 (Primärleiter) elektrisch parallel geschaltet ist, außerhalb des Kerns 4, jedoch in dessen unmittelbarer Nähe, und in Bezug auf den ersten Streifenleiter 1 (Primärleiter) der Sekundärwicklung gegenüberliegend angeordnet. Der als zusätzlicher Leiter dienende Streifenleiter 3 erzeugt dabei einen magnetischen Fluss, der den durch die nur teilweise den Kern 4 umgebende Sekundärwicklung 2 und beispielsweise einen unsymmetrisch innerhalb des Kerns angeordneten Streifenleiter 1 (Primärleiter) hervorgerufene ungleichmäßige Flussverteilung im Kern 4 kompensiert.

Das Ausführungsbeispiel nach Figur 2 geht aus der in Figur 1 gezeigten Ausführungsform dadurch hervor, dass zusätzlich ein rückführender Streifenleiter 5 vorgesehen ist, der gegenüberliegend zum Streifenleiter 3 - in der Nähe der Sekundärwicklung 2 - angeordnet ist und der einen Strom führt, welcher in entgegengesetzter Richtung zu den Streifenleitern 1 und 3 fließt und gleich der Summe der Ströme durch die Streifenleiter 1 und 3 ist. Aufgrund der zu dem Streifenleiter 3 entgegengesetzten Position und entgegengesetzten Stromrichtung ergibt sich insgesamt eine Verstärkung des durch den Streifenleiter 3 (zusätzlicher Leiter) erzeugten Effekts.

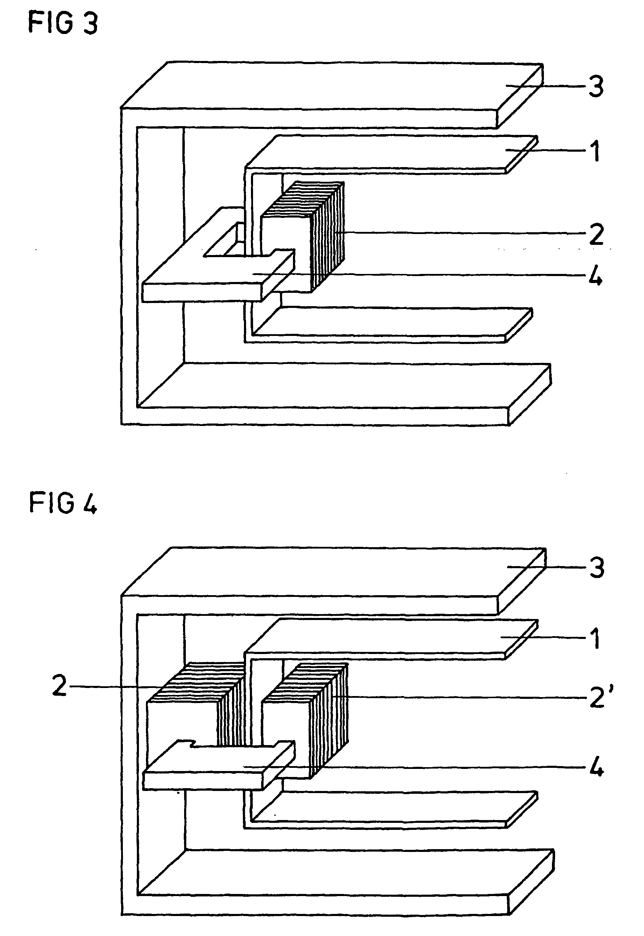

Beim Ausführungsbeispiel nach Figur 3 sind gegenüber der in Figur 1 gezeigten Ausführungsform die Streifenleiter u-förmig ausgebildet. Die U-Form ergibt dabei eine Wicklung mit der Wickungszahl von 0,75. Dabei verlaufen die beiden Streifenleiter 1 und 3 weiterhin parallel, so dass sich zwei ineinander geschachtelte "U" ergeben. Dabei kann der Abstand zwischen den entsprechenden Schenkeln der u-förmigen Streifenleiter 1 und 3 einander gegenüber im Hinblick auf den Abstand im Bereich des Kerns 4 auch verkleinert werden, womit sich der Einfluss von Störfeldern, hervorgerufen durch die Stromzuführung, verringern lässt. Die U-Form bietet insgesamt einen größeren Messbereich.

Bei der in Figur 4 gezeigten Anordnung wird gegenüber Figur 3 zudem eine zusätzliche Sekundärspule 2' vorgesehen, die elektrisch zum Beispiel in Reihe zur Sekundärspule 2 geschaltet ist. Die Sekundärspule 2' ist dabei der Sekundärspule 2 gegenüberliegend, also zwischen den Streifenleitern 1 und 3 den Kern 4 umschließend angeordnet. Auch durch diese Maßnahme lässt sich der Messbereich linearisieren und damit vergrößern.

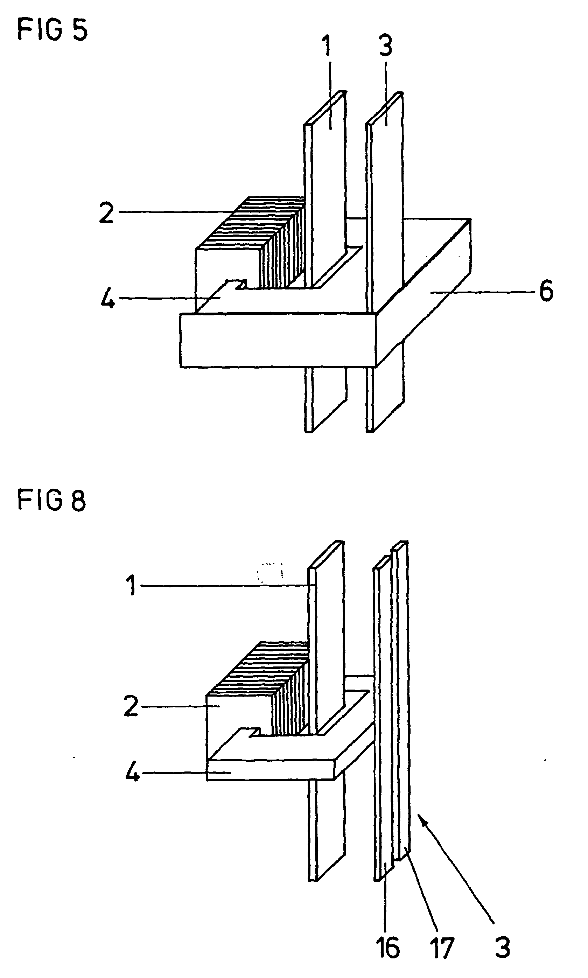

Die Ausführungsform nach Figur 5 geht aus der in Figur 1 gezeigten Ausführungsform dadurch hervor, dass ein u-förmiges Abschirmblech 6 den Kern 4 sowie die Streifenleiter 1 und 3 umgibt. Das Abschirmblech 6 geht dabei von den beiden seitlich zur Sekundärwicklung 2 befindlichen Schenkeln des Kerns 4 aus und verläuft dazu parallel sowie unter Einschluss beider Streifenleiter 1 und 3 auch parallel zu dem der Sekundärwicklung 2 gegenüberliegenden Abschnitt des Kerns 4. Durch das Abschirmblech 6 wird der Einfluss von Störfeldern, die den Messbereich einschränken könnten, verringert und der Messbereich zudem erweitert, da der Kern zusätzlich entlastet wird.

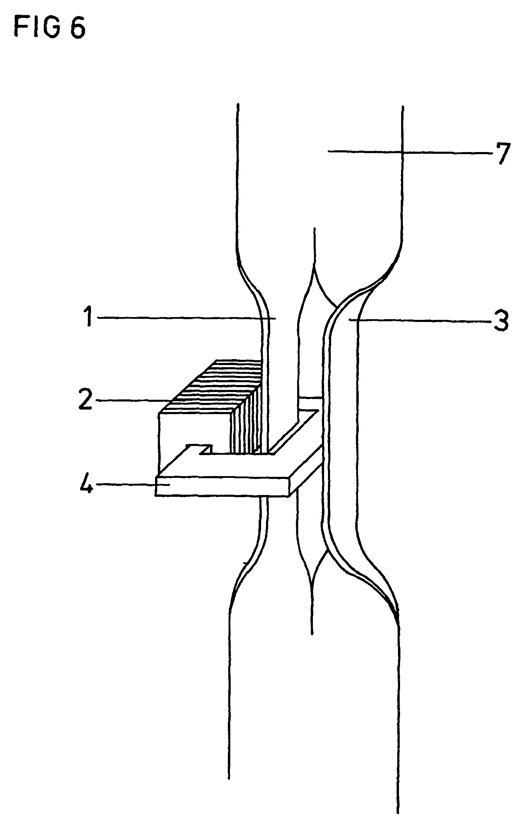

Bei der Ausführungsform nach Figur 6 wird ausgehend von dem Kern 4 und der Sekundärwicklung 2 der bisherigen Ausführungsbeispiele ein Streifenleiter 7 vorgesehen, der im Bereich des Kerns 4 geschlitzt ist und zwei die Streifenleiter 1 und 3 ergebende Teilstreifenleiter bildet. Die Teilstreifenleiter sind gegenüber dem nichtgeschlitzten Bereich des Streifenleiters 7 um 90 Grad gedreht. Durch die einstückige Ausführung des Streifenleiters 7 ergeben sich keine Kontaktstellen der beiden Streifenleiter 1 und 3, wodurch störanfällige Kontaktstellen vermieden werden.

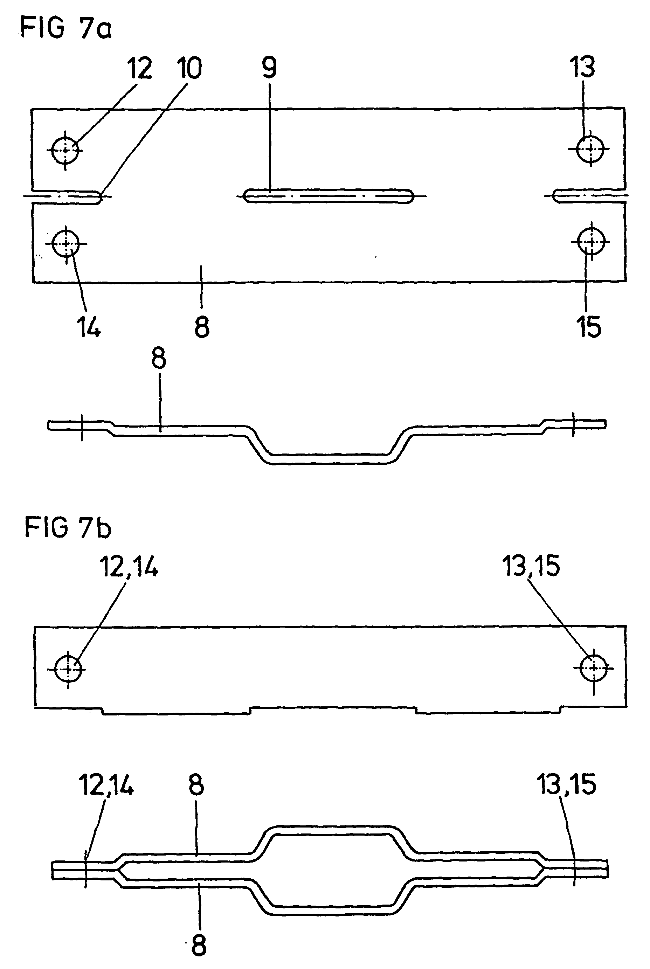

Eine bevorzugte Ausführungsform einer einstückigen Realisierung der Streifenleiter 1 und 3 als einstückiger, geschlitzter Streifenleiter 8 ist in Figur 7 dargestellt. Dabei zeigt im Detail Figur 7a den Aufbau vor und Figur 7b den Aufbau des Streifenleiters 8 nach Durchführung eins Biegevorgangs. Gemäß Figur 7a hat der Streifenleiter 8 eine rechteckige Grundform, wobei in Längsrichtung, also parallel zu den längeren Kanten, drei Schlitze 9, 10, 11 etwa auf halber Breite vorgesehen sind, von denen in Längsrichtung einer 9 in der Mitte und zwei 10, 11 an den seitlichen Rändern angeordnet sind. Der Streifenleiter 8 ist dabei sowohl bezüglich einer quer zur Längsrichtung in deren Mitte verlaufenden Symmetrielinie als auch einer entlang der Schlitze 9, 10, 11 verlaufenden Symmetrielinie symmetrisch aufgebaut. Ausgehend jeweils von den die Schlitze 10 und 11 enthaltenden beiden Seitenrändern ist der Streifenleiter 8 etwa in Höhe der der Mitte zugewandten Enden der Schlitze 10 und 11 gebogen derart, dass sich zwischen diesen beiden Enden insgesamt eine Vertiefung gegenüber den genannten Seitenrändern ergibt, wobei im Bereich des Schlitzes 9 eine weitere Vertiefung vorgesehen ist. Schließlich befinden sich in der Nähe der Ecken Löcher 12, 13, 14, 15, die zumindest hinsichtlich der entlang der Schlitze 9, 10, 11 verlaufenden Symmetrielinie symmetrisch angeordnet sind.

Ausgehend von dieser Grundform wird dann der Streifenleiter 8 gemäß Figur 7b an der entlang der Schlitze 9, 10, 11 verlaufenden Symmetrielinie gebogen derart, dass jeweils zwei der Löcher 12, 14 bzw. 13, 15 übereinander zu liegen kommen. Damit ergibt sich eine Form, die ausgehend von den die Schlitze 10 und 11 enthaltenden Seitenrändern zunächst im Bereich der Löcher 12, 13, 14, 15 dicht aneinander liegen, um sich dann bei der ersten Vertiefung voneinander abzuheben. Im Bereich der zweiten Vertiefung (um den Schlitz 9) ist dabei der Abstand zwischen den beiden Teilen des Streifenleiters 8 am größten. Dieser Teil dient zur Aufnahme des Kerns.

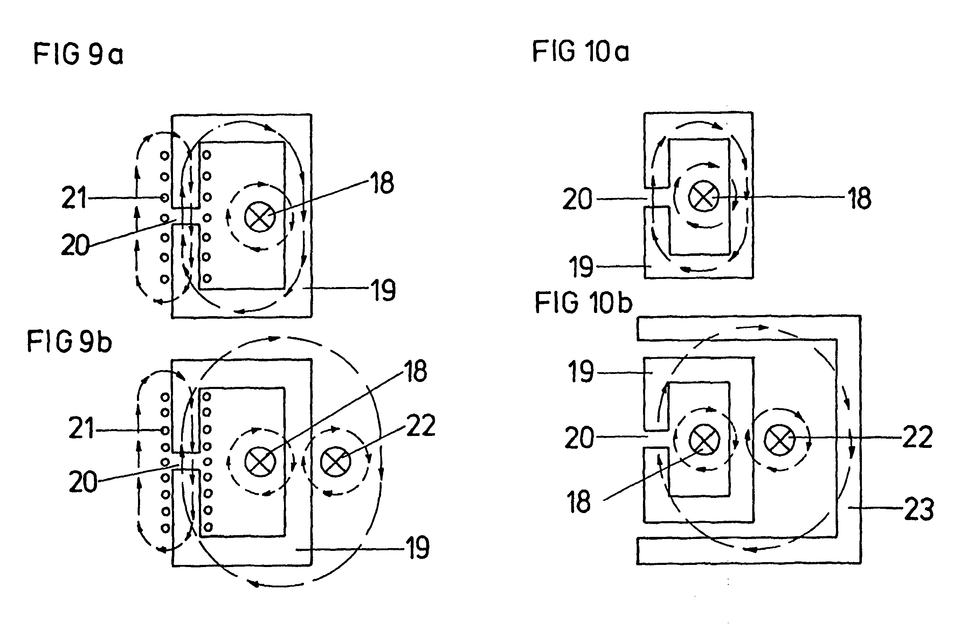

Bei der in Figur 8 gezeigten Ausführungsform wird ausgehend von dem in Figur 1 dargestellten Ausführungsbeispiel der weitere Streifenleiter 3 in zwei parallel zueinander verlaufende Teilstreifenleiter 16 und 17 aufgeteilt, die dann so positioniert werden, dass sie eine optimale Kompensation von Flussüberhöhungen bieten.

In Figur 9 ist dargestellt, wie eine Flussüberhöhung bei einem Stromwandler konventioneller Art (Figur 9a) beispielsweise durch unsymmetrische Anordnung eines (Primär-)Leiters 18 innerhalb eines ringförmigen Kerns 19 mit Luftspalt 20 hervorgerufen wird. Über dem Luftspalt 20 ist eine Sekundärwicklung 21 um den Kern 19 gewickelt, die in der Zeichnung der besseren Übersicht halber im Schnitt gezeigt ist. An dem der Sekundärwicklung 21 gegenüber gelegenen Abschnitt des Kerns 19 (Rückschlusskern) tritt durch eine nicht punktsymmetrische Anordnung des (Primär-)Leiters 18 eine Flussüberhöhung auf, die durch den magnetischen Fluss des (Primär-)Leiters 18 zustande kommt.

Wird nun erfindungsgemäß (Figur 9b) ein "geteilter Leiter", also der (Primär-) Leiter 18 und ein elektrisch parallel geschalteter zusätzlicher Leiter 22, zu beiden Seiten des die Überhöhung aufweisenden Abschnitts des Kerns 19 (Rückschlusskern) vorbeigeführt, dann heben sich die Feldlinien gegenseitig wieder auf und das resultierende magnetische Feld ist gleich null. Dadurch erhöht sich der Messbereich nicht nur um den Faktor der Stromaufteilung zwischen den Leitern 18 und 22, sondern um das Produkt der Stromaufteilung (Verhältnis vom Gesamtstrom zu Anteil des gemessenen Stroms) und Meßbereichserweiterung des Stromsensors (Verhältnis aus "normalem" Messbereich zu Messbereich bei erfindungsgemäßer Anordnung). Wird zum Beispiel bei der Anordnung nach Figur 9b nur der halbe Strom (Stromaufteilungsfaktor 2) über den Leiter 18 geführt, dann ergibt sich eine Messbereichserweiterung von 1,36 und eine Erweiterung des linearen Messbereichs auf das 2,72-fache. Ein herkömmlicher Stromsensor mit 75 Ampere könnte bei Anwendung der Erfindung damit auf linearen Messbereich von 190 Ampere gebracht werden. Bei einem Stromaufteilungsfaktor von 5 ergibt sich eine Messbereichserweiterung des Stromsensors auf etwa 1000 Ampere.

Bei einer noch höheren Stromaufteilung (zum Beispiel Faktor 9) ergibt sich eine Aufmagnetisierung des Rückschlusskerns durch den zusätzlichen Leiter 22 und dadurch ein positiver Linearitätsfehler bei hohen Strömen. Um auch hier größere Messbereiche zu ermöglichen, muss bei gegebenem Abstand des (Primär-)Leiters 18 der Abstand des zusätzlichen Leiters zum Rückschlusskern erhöht werden. Durch Variation von Stromaufteilung und/oder Abständen kann also der Stromsensor auf maximalen Messbereich eingestellt werden.

In Figur 10 ist die Wirkung eines Abschirmblechs 23 bei einer Anordnung nach Figur 9b gegenüber einer herkömmlichen Anordnung nach Figur 9a gezeigt, wobei die Sekundärwicklung bei beiden weggelassen wurde. Durch das Abschirmblech 23 wird das durch die Leiter 18 und 22 erzeugte Magnetfeld weiter homogenisiert und über im Kern 19 nur über den den Spalt 20 aufweisenden Abschnitt des Kerns 19 geführt.

## Patentansprüche

1. Stromwandler für einen Kompensationsstromsensor mit einem Primärleiter (1), einer Sekundärwicklung (2) und einem weichmagnetischen Kern (4),
bei dem der Kern (4) einen Spalt (20) aufweist und durch die Sekundärwicklung nur teilweise umwickelt ist,
bei dem Primärleiter (1) und Sekundärwicklung (2) elektrisch voneinander isoliert und magnetisch durch den Kern (4) miteinander gekoppelt sind und
bei dem der Primärleiter (1) zur Einspeisung eines zu erfassenden Stromes und die Sekundärwicklung (2) zur Erfassung eines Kompensationsstromes vorgesehen ist,
**gekennzeichnet durch**
einen zusätzlichen Leiter (3), der dem Primärleiter (1) elektrisch parallel geschaltet ist und der in dem Bereich des Kerns (4) angeordnet ist, an dem eine Flussüberhöhung auftritt, wobei die Flussüberhöhung **durch** den Fluss, der **durch** den in dem zusätzlichen Leiter (3) fließenden Strom hervorgerufen wird, zumindest teilweise kompensiert wird.

2. Stromwandler nach Anspruch 1, **dadurch gekennzeichnet, dass** der zusätzliche Leiter (3) und der Primärleiter (1) bezüglich eines Abschnitts des Kerns (4) sich gegenüber stehen.

3. Stromwandler nach einem der vorherigen Ansprüche, **dadurch gekennzeichnet, dass** mindestens ein zweiter zusätzlicher Leiter (16, 17) vorgesehen ist, der den anderen beiden (1, 3) elektrisch parallel geschaltet ist und daß die beiden zusätzlichen Leiter (16, 17) bezüglich eines Abschnitts des Kerns (4) sich gegenüber stehen.

4. Stromwandler nach einem der vorherigen Ansprüche, **dadurch gekennzeichnet, dass** Primärleiter (1) und zusätzliche(r) Leiter (3, 16, 17) unterschiedlicher Stärke führen, wobei die Ströme in Summe den zu erfassenden Strom ergeben.

5. Stromwandler nach einem der vorherigen Ansprüche, **dadurch gekennzeichnet, dass** Primärleiter (1) und zusätzliche(r) Leiter (3, 16, 17) Windungszahlen aufweisen, die kleiner als eins sind.

6. Stromwandler nach Anspruch 5, **dadurch gekennzeichnet, dass** Primärleiter (1) und zusätzliche(r) Leiter (3, 16, 17) durch einen im Bereich des Kerns (4) im Wesentlichen geradlinigen Leiter gebildet werden.

7. Stromwandler nach Anspruch 5, **dadurch gekennzeichnet, dass** Primärleiter (1) und zusätzliche(r) Leiter (3, 16, 17) durch einen im Bereich des Kerns (4) im Wesentlichen u-förmigen Leiter gebildet werden.

8. Stromwandler nach Anspruch 5, **dadurch gekennzeichnet, dass** Primärleiter (1) und/oder zusätzliche(r) Leiter (3, 16, 17) durch einen einstückigen geschlitzten Leiter gebildet werden.

9. Stromwandler nach einem der vorherigen Ansprüche, **dadurch gekennzeichnet, dass** ein rückführender Leiter (5) vorgesehen ist, der neben dem Kern (4), auf der den zusätzlichen Leitern (3, 16, 17) entgegengesetzten Seite des Kerns (4) angeordnet ist und der von dem zu erfassenden Strom in der gegenüber den zusätzlichen Leitern (3, 16, 17) entgegengesetzten Richtung durchflossen wird.

10. Stromwandler nach einem der vorherigen Ansprüche, **dadurch gekennzeichnet, dass** Primärleiter (1), zusätzliche(r) Leiter (3, 16, 17), Sekundärwicklung (2) und Kern (4) zumindest teilweise von einem Abschirmblech (6) umgeben sind.

## Claims

1. Current transformer for a compensating current sensor having a primary conductor (1), a secondary winding (2) and a soft-magnetic core (4),
in which the core (4) has a gap (20) and the secondary winding is wound round only part of said core,
in which the primary conductor (1) and the secondary winding (2) are electrically isolated from one another and are coupled to one another magnetically by means of the core (4), and
in which the primary conductor (1) is provided for the purpose of feeding in a current to be detected, and the secondary winding (2) is provided for the purpose of detecting a compensating current,
**characterized by**
an additional conductor (3), which is connected electrically in parallel with the primary conductor (1) and which is arranged in the region of the core (4) at which there is a flux peak, the flux peak being at least partially compensated for by the flux produced by the current flowing in the additional conductor (3).

2. Current transformer according to Claim 1, **characterized in that** the additional conductor (3) and the primary conductor (1) are positioned opposite one another with respect to one section of the core (4).

3. Current transformer according to one of the preceding claims, **characterized in that** at least one second additional conductor (16, 17) is provided and is connected electrically in parallel with the other two (1, 3), and **in that** the two additional conductors (16, 17) are positioned opposite one another with respect to one section of the core (4).

4. Current transformer according to one of the preceding claims, **characterized in that** the primary conductor (1) and the additional conductor(s) (3, 16, 17) have different current intensities, the sum of these currents giving the current to be detected.

5. Current transformer according to one of the preceding claims, **characterized in that** the primary conductor (1) and the additional conductor(s) (3, 16, 17) have less than one turn.

6. Current transformer according to Claim 5, **characterized in that** the primary conductor (1) and the additional conductor(s) (3, 16, 17) are in the form of a conductor which is essentially straight in the region of the core (4).

7. Current transformer according to Claim 5, **characterized in that** the primary conductor (1) and the additional conductor(s) (3, 16, 17) are in the form of a conductor which is essentially U-shaped in the region of the core (4).

8. Current transformer according to Claim 5, **characterized in that** the primary conductor (1) and/or the additional conductor(s) (3, 16, 17) are/is in the form of an integral conductor with a slot.

9. Current transformer according to one of the preceding claims, **characterized in that** a return flow conductor (5) is provided which is arranged next to the core (4) on the opposite side of the core (4) to the additional conductors (3, 16, 17) and through which the current to be detected flows it in the opposite direction to that of the additional conductors (3, 16, 17).

10. Current transformer according to one of the preceding claims, **characterized in that** the primary conductor (1), the additional conductor(s) (3, 16, 17), the secondary winding (2) and the core (4) are at least partially surrounded by a screening plate (6).

## Revendications

1. Transformateur de courant pour un détecteur de courant de compensation comportant un conducteur primaire (1), un enroulement secondaire (2) et un noyau magnétique doux (4),
pour lequel le noyau (4) présente un entrefer (20) et n'est que partiellement entouré par l'enroulement secondaire, le conducteur primaire (1) et l'enroulement secondaire (2) sont électriquement isolés l'un de l'autre et sont magnétiquement couplés l'un à l'autre par le noyau (4), le conducteur primaire (1) étant prévu pour fournir un courant à détecter et l'enroulement secondaire pour fournir un courant de compensation,
**caractérisé par**
un conducteur supplémentaire (3) électriquement monté en parallèle au conducteur primaire (1) et disposé dans la zone du noyau (4) sur laquelle apparaît une élévation du flux, l'élévation du flux étant au moins en partie compensée par le flux provoqué par le courant qui traverse le conducteur supplémentaire (3).

2. Transformateur de courant selon la revendication 1,
**caractérisé en ce que**
le conducteur supplémentaire (3) et le conducteur primaire (1) se font face l'un l'autre par rapport à un segment du noyau (4).

3. Transformateur de courant selon l'une des revendications précédentes,
**caractérisé en ce que**
l'on prévoit au moins un deuxième conducteur supplémentaire (16, 17) qui est électriquement monté en parallèle par rapport aux deux (1, 3) autres et les deux conducteurs supplémentaires (16, 17) se font face l'un l'autre par rapport à un segment du noyau (4).

4. Transformateur de courant selon l'une des revendications précédentes,
**caractérisé en ce que**
le conducteur primaire (1) et le (les) conducteur(s) supplémentaire(s) (3, 16, 17) conduisent des courants de différentes intensités, les courants additionnés donnant le courant à détecter.

5. Transformateur de courant selon l'une des revendications précédentes,
**caractérisé en ce que**
le conducteur primaire (1) et le (les) conducteur(s) supplémentaire(s) (3, 16, 17) présentent des nombres d'enroulement qui sont inférieurs à un.

6. Transformateur de courant selon la revendication 5,
**caractérisé en ce que**
le conducteur primaire (1) et le (les) conducteur(s) supplémentaire(s) (3, 16, 17) sont formés par un conducteur pratiquement rectiligne dans la zone du noyau (4).

7. Transformateur de courant selon la revendication 5,
**caractérisé en ce que**
le conducteur primaire (1) et le (les) conducteur(s) supplémentaire(s) (3, 16, 17) sont formés par un conducteur pratiquement en U dans la zone du noyau (4).

8. Transformateur de courant selon la revendication 5,
**caractérisé en ce que**
le conducteur primaire (1) et le (les) conducteur(s) supplémentaire(s) (3, 16, 17) sont formés par un conducteur fendu et en une seule pièce.

9. Transformateur de courant selon l'une des revendications précédentes,
**caractérisé en ce qu'**
on prévoit à côté du noyau (4) un conducteur de retour (5) qui est placé du côté du noyau (4) opposé aux autres conducteurs supplémentaires (3, 16, 17) et qui est traversé par le courant à détecter dans le sens opposé aux conducteurs supplémentaires (3, 16, 17).

10. Transformateur de courant selon l'une des revendications précédentes,
**caractérisé en ce que**
le conducteur primaire (1), le (les) conducteur(s) supplémentaire(s) (3, 16, 17), l'enroulement secondaire (2) et le noyau (4) sont au moins en partie entourés par une tôle de protection (6).
